(19) Europäisches Patentamt
European Patent Office
Office européen des brevets

(11) Publication number: **0 349 157 A2**

# (12) EUROPEAN PATENT APPLICATION

(21) Application number: 89306039.2

(22) Date of filing: 14.06.89

(51) Int. Cl.[4]: G03F 7/075

(30) Priority: 28.06.88 JP 159916/88

(43) Date of publication of application:
03.01.90 Bulletin 90/01

(84) Designated Contracting States:
DE GB

(71) Applicant: KONICA CORPORATION
No. 26-2, Nishishinjuku 1-chome Shinjuku-ku
Tokyo(JP)

(72) Inventor: Nakajima, Akihisa
Konica Corporation 1 Sakura-machi
Hino-shi Tokyo(JP)
Inventor: Suzuki, Norihito
Konica Corporation 1 Sakura-machi
Hino-shi Tokyo(JP)

(74) Representative: Brock, Peter William et al
URQUHART-DYKES & LORD 91 Wimpole Street
London W1M 8AH(GB)

## (54) A waterless presensitized lithographic printing plate.

(57) A waterless presensitized lithographic printing plate is disclosed. The plate comprises a support having thereon a light-sensitive layer and a silicone rubber layer in this order, wherein said silicone rubber layer contains a copolymer having a silicone macromer and a fluorine-containing monomer in its molecular structure.

EP 0 349 157 A2

# A WATERLESS PRESENSITIZED LITHOGRAPHIC PRINTING PLATE

## FIELD OF THE INVENTION

The present invention relates to a waterless presensitized lithographic printing plate, more specifically to a waterless presensitized lithographic printing plate whose nonimaging portion is not easily scratched.

## BACKGROUND OF THE INVENTION

A waterless presensitized lithographic printing plate (hereinafter referred to as a waterless PS plate) usually comprises a support and a light sensitive layer and silicone rubber layer formed thereon in this order. The use of a waterless printing plate obtained by exposing and developing this waterless PS plate permits printing based on the ink acceptance of the light sensitive layer and the ink repellence of the silicone rubber layer.

However, such a waterless printing plate has a faulty that it is difficult to obtain a sufficient adhesion between the light sensitive layer and the silicone rubber layer, the nonimaging portion easily has scratches, and the small dot image reproducibility is poor.

With the aim of solving these problems, a method was proposed in which a silane compound is added to silicone rubber layer, disclosed in Japanese Patent O.P.I. Publication No. 288849/1987. This method, however, exerts an adverse effect on the ink repellence, an essential property, of the silicone rubber layer, which in turn degrades the printability.

With the aim of overcoming this drawback, the present inventor proposed a method using a unique silicone graft copolymer in the silicone rubber layer, which is disclosed in Japanese Patent Application No. 159915/1988.

The present inventor made further investigations of this method, and found that it has a faulty that stains at nonimaging portion (hereinafter referred to as field stains) occur under high temperature (28° to 35° C) conditions in summer, though good image reproducibility is obtained when the printing plate surface is maintained at low temperature.

## SUMMARY OF THE INVENTION

The object of the present invention is to provide a waterless presensitized lithographic printing plate whose nonimaging portion is not easily scratched, which exerts no adverse effect on the ink repellence of the silicone rubber layer, which has improved printability, and whioh is free of possibility of cause field stains under high temperature conditions.

## DETAILED DESCRIPTION OF THE INVENTION

The present inventor made intensive investigations to accomplish the above object, and developed the present invention.

Accordingly, the waterless presentitized lithographic printing plate of the present invention comprises a support having thereon a light-sensitive layer and a silicone rubber layer in this order, wherein said silicone rubber layer contains a copolymer having a silicone macromer and a fluorine-containing monomer in its molecular structure.

The silicone macromer of the present invention, when used singly, shows good image reproducibility without causing a field stain at low printing plate surface temperatures, but it causes severe field stains under high temperature conditions in summer. Although the cause of this phenomenon remains unknown, the use of a copolymer obtained by copolymerizing the silicone macromer with a fluorine-containing monomer in the silicone rubber layer has made it possible to obtain excellent characteristics of the silicone macromer while reducing the possibility of field stains even under high temperature conditions.

The support of the present invention is preferably a material which is sufficiently flexible so that it can be applied to ordinary lithography machines and which withstands the load exerted during the printing process. The examples of the support include metal plates such as of aluminum, zinc, copper and steel; metal plates, paper, plastic films and glass plates plated or vapor deposited with chromium, zinc, copper, nickel, aluminum, iron or other metal; resin coated paper; and paper coated with aluminum or other metal. Among these materials, aluminum plates are preferred.

There is no particular limitation on the choice of treatment of the support itself to improve the adhesion; various surface roughing treatments can be conducted.

The support may have a primer layer. The examples of the resin contained in the primer layer include polyester resin, vinyl chloride-vinyl acetate copolymer, acrylic resin, vinyl chloride resin, polyamide resin, polyvinyl butyral resin, epoxy resin, acrylate copolymer, vinyl acetate copolymer, phenoxy resin, polyurethane resin, polycarbonate resin, polyacrylonitrile butadiene and polyvinyl acetate. Epoxy resin is especially preferable.

The examples of the anchor agent composing the primer layer include silane coupling agents and silicone primers used in the silicone rubber layer; organic titanates and other anchor agents are also effective.

The silane coupling agent is a silane compound represented by the formula:

$(R)_nSiX_{4-n}$

wherein n represents an integer of 1 to 3; $R^1$ represents an alkyl group, aryl group, alkenyl group or monovalent group comprising a combination thereof, which may have a functional group such as a halogen atom, an amino group, a hydroxy group, an alkoxy group, an aryloxy group or a thiol group; X represents a substituent such as -OH, $-OR^2$, $-OCOCH_3$,

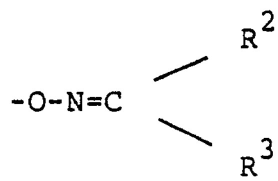 ,

$-Cl$, -Br or -I; $R^2$ and $R^3$ have the same definitions as R above, whether they are identical or not. The examples of the silane compound include $HN[(CH_2)_3Si(OCH_3)_3]_2$, vinyltrichlorosilane, vinyltriethoxysilane, $Cl(CH_2)_3Si(OCH_3)_3$, $CH_3Si(-OCOCH_3)_3$, $HS(CH_2)_3Si(OCH_3)$ and vinyltris(methylethylketoxime) silane.

There is no particular limitation of the choice of the light sensitive material for the light sensitive layer of the present invention. As examples of the light sensitive material, mention may be made of quinone diazide type positive type light sensitive materials such as well-known o-naphthoquinonediazide compounds. The examples of the preferable o-naphthoquinonediazide compound include the ester of naphthoquinone-(1,2)-diazide-(5)-sulfonic acid chloride and phenol or cresol-formaldehyde resin, disclosed in U.S. Patent No. 3,046,120. The examples of other useful o-naphthoquinonediazide compounds include the ester of pyrogallol-acetone resin and o-naphthoquinonediazide sulfonic acid chloride, disclosed in U.S. Patent No. 3,635,709, the ester of polyhydroxyphenyl resin and o-naphthoquinonediazidesulfonic acid chloride, disclosed in Japanese Patent O.P.I. Publication Nos. 76346/1980, 1044/1981 and 1045/1981, the product obtained by esterifying a p-hydroxystyrene homopolymer or copolymer of p-hydroxystyrene and copolymerizable monomer with o-naphthoquinonediazidesulfonic acid chloride, disclosed in Japanese Patent O.P.I. Publication No. 113305/1975, the reaction product of a styrene monomer-phenol derivative polymer and o-quinonediazidesulfonic acid, disclosed in Japanese Patent Examined Publication No. 17481/1974, and the ester of polyhydroxybenzophenone and o-naphthoquinonediazidesulfonic acid chloride.

The light sensitive composition containing such a quinonediazide type positive type light sensitive material may contain a binder added as needed. the examples of preferable binders include novolac resins soluble in aqueous alkali solutions. Representative examples of such novolac resins include phenol-formaldehyde resin, cresol-formaldehyde resin, p-tert-butylphenol-formaldehyde resin and phenol-modified xylene resin.

The quinonediazide compound content of the light sensitive layer is 10 to 50% by weight, preferably 20 to 40% by weight. The ratio of the binder is 45 to 80% by weight, preferably 50 to 70% by weight, relative to the light sensitive layer composition.

The following light sensitive materials can be used for the present invention. For example, it is possible to use diazo resins exemplified by condensation products of aromatic diazonium salts and formaldehyde. The examples of especially preferable diazo resins include diazo resin inorganic salts obtained by reaction

of the above condensation product and a salt, such as hexafluorophosphate, tetrafluoroborate, perchlorate or periodate, of the condensation product of p-diazodiphenylamine and formaldehyde or acetaldehyde; diazo resin organic salts obtained by reaction of the above condensation product and sulfonic acid as disclosed in U.S. Patent No. 3,300,309. The diazo resin is preferably used in combination with a binder. Various high polymer compounds can be used as binders for this purpose. The examples of preferable binders include copolymers of a monomer having an aromatic hydroxy group, such as N-(4-hydroxyphenyl)acrylamide, N-(4-hydroxyphenyl)methacrylamide, o-, m- or p-hydroxystyrene, o-, m- or p-hydroxyphenyl methacrylate or other monomer, as disclosed in Japanese Patent O.P.I. Publication No. 98613/1979, polymers consisting mainly of repeat units of hydroxyethyl acrylate or hydroxyethyl methacrylate, as disclosed in U.S. Patent No. 4,123,276, natural resins such as shellac and rosin, polyvinyl alcohol, the polyamide resin disclosed in U.S. Patent No. 3,751,257, the linear polyurethane resin disclosed in U.S. Patent No. 3,660,097, polyvinyl alcohol phthalate resin, epoxy resins obtained by condensation of bisphenol A and epichlorohydrin, and celluloses such as cellulose acetate and cellulose acetate phthalate.

Mention may also be made of light sensitive materials consisting mainly of a light sensitive polymer having $-CH=CH-\underset{\underset{O}{\|}}{C}-$ as the light sensitive group in its polymer main chain or side chain, such as polyesters, polyamides and polycarbonates. The examples of such light sensitive materials include light sensitive polyesters obtained by condensation of phenylenediethyl acrylate, hydrogenated bisphenol A and triethylene glycol, as disclosed in Japanese Patent O.P.I. Publication No. 40415/1980, and light sensitive polyesters derived from a (2-propelidene)malonic acid compound such as cinnamylidenemalonic acid and a bifunctional glycol, as disclosed in U.S. Patent No. 2,956,878.

Mention may also be made of aromatic azide compounds in which the azide group is bound to the aromatic ring directly or via a carbonyl or sulfonyl group. The examples of the aromatic azide compound include polyazidestyrene, polyvinyl-p-azidobenzoate, and polyvinyl-p-azidobenzal, as disclosed in U.S. Patent No. 3,096,311; the reaction product of azidoarylsulfanyl chloride and unsaturated hydrocarbon polymer disclosed in Japanese Patent Examined Publication No. 9613/1970; and polymers having sulfonylazide or carbonylazide as disclosed in Japanese Patent Examined Publication Nos. 21067/1968, 229/1969, 22954/1969 and 24915/1970.

Photopolymerizable compositions comprising an addition-polymerizable unsaturated compounds may also be mentioned.

The examples of the photopolymerizable monomer used in this composition include methacrylates having hydrophilicity such as ethylene glycol mono- or dimethacrylate, polyethylene glycol mono- or dimethacrylate, hydroxyethyl methacrylate, hydroxypropyl(meth)acrylate, glycidyl(meth)acrylate, hydroxyphenylamino(meth)acrylate, 1-chloro-2-hydroxyethyl(meth)acrylate and dimethylaminoethyl (meth)-acrylate; acrylamide derivatives such as ethylene bisacrylamide, N-methylolacrylamide and methoxymethylacrylamide; allyl alcohol esters such as triacryl cyanurate, triacryl phosphate, diallyl phthalate and diallyl malate; other styrene derivatives; and cinnamic acid derivatives.

The examples of the photosensitizer used in this composition include benzophenone derivatives, benzoin derivatives, anthraquinone derivatives, aldehydes, ketones, sulfur compounds, halides, and dyes such as methylene blue and riboflavin.

Light sensitive materials used for electrophotography printing plates can also be used for the present invention. The examples of such materials include the electron donor compound for electrophotography printing plates disclosed in Japanese Patent O.P.I. Publication No. 161250/1980 and light sensitive compositions comprising phthalocyanine pigment and phenol resin.

In addition to the above materials, the light sensitive layer may contain dyes for image visualization after exposure or development (e.g. Victoria Pure Blue BOH, produced by Hodogaya Chemical, Oil Blue #603, produced by Orient Chemical, and other tri- or diphenylmethane dyes), alkyl ethers for improvement of coating property (e.g. ethylcellulose, methylcellulose), fluorine surfactants, nonionic surfactants (e.g. pluronic L64, produced by Asahi Denka), plasticizers for providing film flexibility (e.g. polyethylene glycol, tricresyl phosphate, acrylic or methacrylic polymers), and stabilizers (e.g. phosphoric acid, oxalic acid, tartaric acid).

The silicone rubber layer of the present invention contains a copolymer of silicone macromer and fluorine-containing monomer (hereinafter referred to as the copolymer of the present invention).

The copolymer of the present invention is obtained by ordinary radical copolymerization.

The silicone macromer of the present invention is represented by the formula (I):

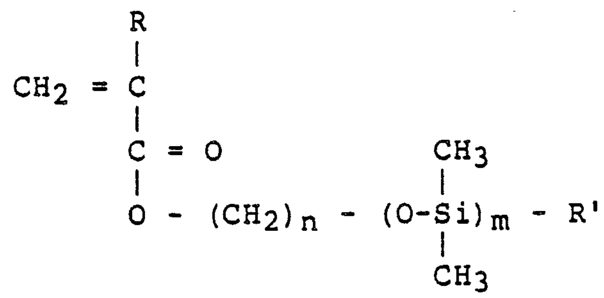

(I)

wherein R represents a hydrogen atom or methyl group; R′ represents an alkyl group or a hydroxyl group; n represents an integer of 0, 1, or 2; m represents an integer of 1 to 150.

The examples of the macromer include the acryl-modified silicone obtained by condensation of α, ω-dihydroxydimethylpolysiloxane and γ-methacryloxypropylmethyldichlorosilane in a molar ratio of 1 to 0.25 of the former to 1 of the latter. The commercially available products of the macromer include Silaprene, produced by Chisso Corporation, which is available under the following product numbers:

TM 0701 (n = 3, m = 1)
FM 0711 (n = 3, m = 10)
FM 0721 (n = 3, m = 64)

The fluorine-containing monomer used for the present invention is represented by the following formula (II):

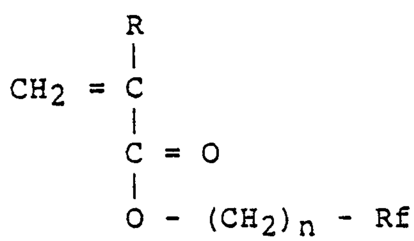

(II)

wherein R represents a hydrogen atom or a methyl group; Rf represents a fluorinated alkyl group having not more than 20 carbon atoms; n represents an integer of 0, 1 or 2. The Rf, preferably, comprises at least one group selected from the group consisting of $-CF_3$, $-CF_2-$, -CF-, $-OCF_3$, $-OCF_2-$, -OCF-.

The fluorine content of Rf is not less than 30% by weight, preferably not less than 50% by weight.

Examples of the fluorine monomer used for the present invention are given below, but these are not to be construed as limitations.

Example Monomers

(1)

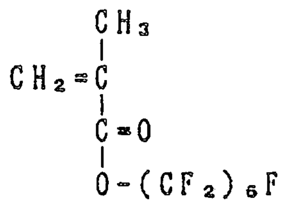

(2)

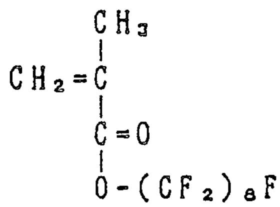

(3)

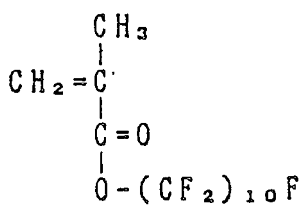

(4)

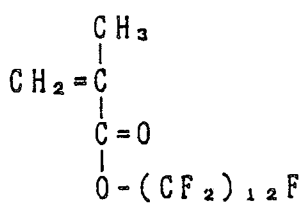

(5)

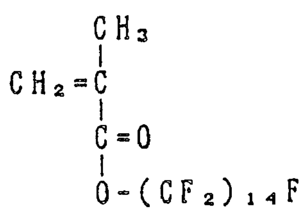

(6)

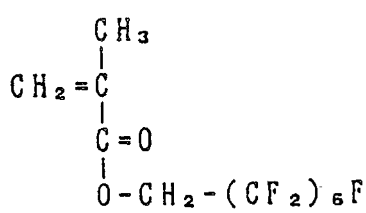

(7)

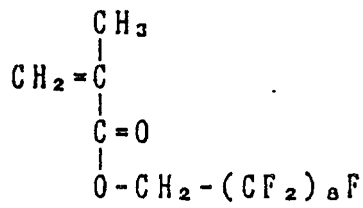

(8)

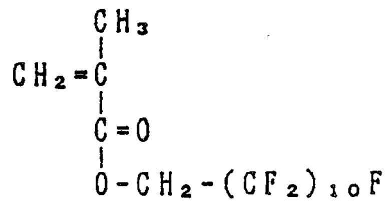

(9)

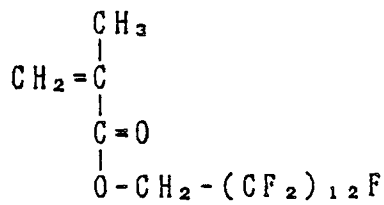

(10)

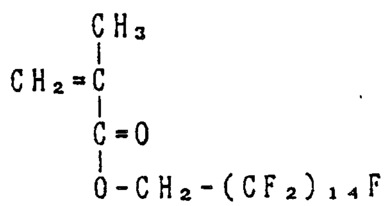

(11)

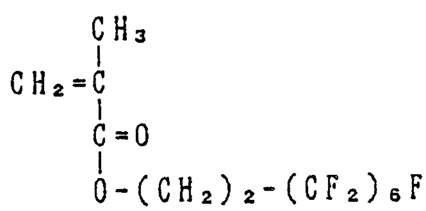

(12)

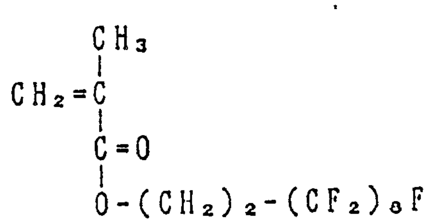

(13) 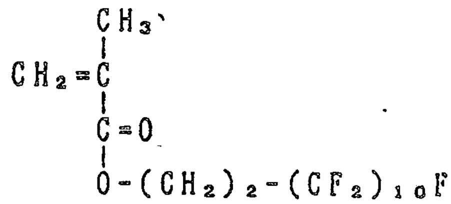

(14) 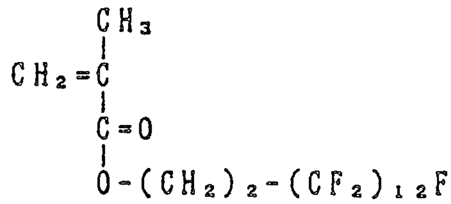

(15) 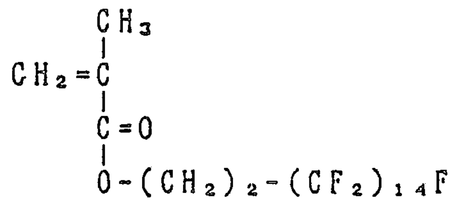

(16) 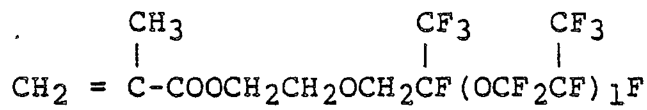

(17) 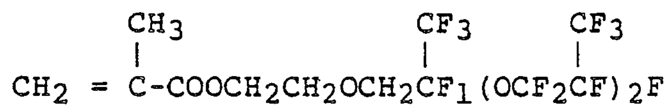

(18) 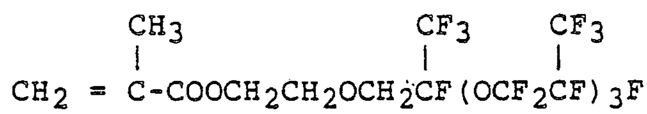

(19) 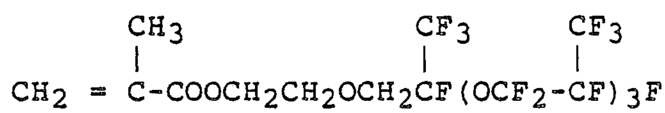

(20) $CF_3(CF_2)_7CH_2CH_2OCOCH = CH_2$
(21) $CF_3(CF_2)_4CH_2OCOC(CH_3) = CH_2$

(22) 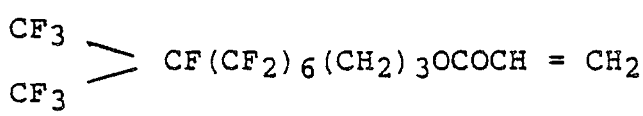

(23) 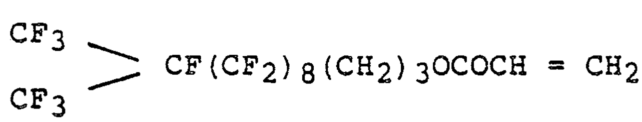

(24) 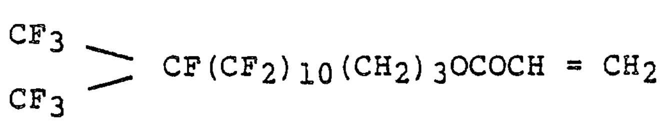

(25) $CF_3(CF_2)_6(CH_2)_2OCOC(CH_3) = CH_2$

(26) $\begin{matrix} CF_3 \\ CF_3 \end{matrix} > CF(CF_2)_9(CH_2)_2OCOCH = CH_2$

(27) $CF_3(CF_2)_7SO_2N(C_3H_7)(CH_2)_2OCOCH = CH_2$
(28) $CF_3(CF_2)_7(CH_2)_4OCOCH = CH_2$
(29) $CF_3(CF_2)_7SO_2N(CH_3)(CH_2)_2OCOC(CH_3) = CH_2$
(30) $CF_3(CF_2)_6COOCH = CH_2$

(31) $\begin{matrix} CF_3 \\ CF_3 \end{matrix} > CF(CF_2)_6CH_2CH(OCOCH_3)OCOC(CH_3) = CH_2$

(32) $\begin{matrix} CF_3 \\ CF_3 \end{matrix} > CF(CF_2)_6CH_2CH(OH)CH_2OCOCH = CH_2$

(33) $CH_2 = CH\text{-}COO\text{-}(CF_2)_6F$
(34) $CH_2 = CH\text{-}COO\text{-}(CF_2)_8F$
(35) $CH_2 = CH\text{-}COO\text{-}(CF_2)_2(CF_2)_8F$
(36) $CH_2 = CHCOO(CH_2)_2\text{-}(F_2)_{10}F$

The silicone rubber layer of the present invention may contain a graft polymer having polyorganosiloxane in its branch (hereinafter referred to as the graft polymer of the present invention).

The graft polymer of the present invention is synthetically obtained. The examples of the synthesis method include the following:

(1) The method in which an active group is formed by hydrogen abstraction from the lower alkyl group bound to each silicon atom of the silicone, and grafted with an organic polymer to yield a silicone graft polymer, as seen in Japanese Patent Examined Publication Nos. 6896/1957 and 16199/1972 and Japanese Patent O.P.I. Publication No. 28389/1973.

(2) The method in which reaction is carried out between a silicone having an active group and a living polymer obtained by anion polymerization to yield a silicone graft polymer, as seen in Japanese Patent Examined Publication No. 9355/1971.

(3) The method in which a polysiloxane polyester containing maleic acid in its main chain is synthesized and graft polymerized with an electro donor monomer that easily forms a charge-transfer complex with maleic acid to yield a silicone graft polymer, as seen in Japanese Patent Examined Publication No. 135391/1977.

(4) The method in which a silicone graft polymer is obtained by radical copolymerization of an acryl-modified silicone obtained by condensation of $\alpha$, $\omega$-dihydroxydimethylpolysiloxane and $\gamma$-methacryloxypropylmethyldichlorosilane in a molar ratio of 1 to 0.25 of the former to 1 of the latter and a monomer that is radical-polymerizable with the acryl-modified silicone (this method is hereinafter referred to as the method based on radical copolymerization of acryl-modified silicone and monomer).

Particularly, the silicone graft polymer obtained by the method based on radical copolymerization of acryl-modified silicone and monomer is highly soluble in organic solvents.

The silicone content of the copolymer of the present invention is preferably 10 to 95% by weight, more preferably 60 to 95% by weight (here, the silicone content of the copolymer is determined as the $SiO_2$ content after burning the copolymer). When the silicone content is less than 10% by weight, the obtained film surface reforming effect is unsatisfactory. When the silicone content exceeds 95% by weight, the solubility in organic solvents is degraded.

The fluorine-containing monomer content of the copolymer of the present invention is preferably 0.1 to 50% by weight, more preferably 0.1 to 20% by weight.

The copolymer of the present invention is a graft copolymer comprising a copolymer obtained from a radical-polymerizable monomer as the stem and a silicone-fluorine monomer as the branch. The number of branching points in the graft copolymer can be deduced from the molecular weights of the acryl-modified silicone, radical-polymerizable monomer and graft copolymer, and the silicone and fluorine monomer contents of the graft copolymer.

The ratio of copolymer used in the silicone rubber layer of the present invention is 80 to 100% by

weight, preferably 90 to 100% by weight, at which the copolymer is very effective.

The copolymer can be added by any method, including the method in which the copolymer is added directly to organic solvent, and the method in which a solution of the copolymer in an appropriate solvent is added to organic solvent. The examples of the organic solvent for this purpose include the organic solvents used for developers mentioned below.

In the present invention, the silicone rubber layer may contain a small amount of photosensitizing agent, as well as the above-mentioned compounds.

The thickness of each layer composing the waterless PS plate of the present invention is 50 to 400 µm, preferably 100 to 300 µm for the support, 0.05 to 10 µm, preferably 0.5 to 5 µm for the light sensitive layer, and 0.5 to 100 µm, preferably 1 to 40 µm for the silicone rubber layer.

In the present invention, the silicone rubber layer may have a protective layer formed on the upper face thereof as needed.

The waterless PS plate of the present invention can, for example, be produced as follows:

On the support, a solution of the composition to comprise the light sensitive layer is coated and dried and, if necessary, thermally cured, by means of an ordinary coater such as a reverse roll coater, air knife coater or Meyer bar coater, or rotary coater such as a whirler. Also, a primer layer may be formed, as needed, between the support and the light sensitive layer in the same manner as the light sensitive layer. A silicone rubber solution is then coated on the light sensitive layer in the same manner as above, and thermally treated normally at 100 to 120 °C for several minutes until it hardens sufficiently to yield a silicone rubber layer. A protective film may be formed on the silicone rubber layer by means of a laminator or other means as needed.

The process of producing a waterless printing plate by the use of the waterless PS plate of the present invention is described below.

The original positive film is brought into close contact with the surface of the positive type waterless PS plate in a vacuum, and exposed to light. The light sources that can be used for exposure include mercury vapor lamps, carbon arc lamps, xenon lamps, metal halide lamps, fluorescent lamps and other lamps that generate high intensities of ultra violet rays.

The positive film is then stripped and developed with a developer. Known developers for waterless PS plates can be used for the development. The examples of suitable developers include mixtures of an aliphatic hydrocarbon (e.g. hexane, heptane, "Isopar E, H, G, tradenames for aliphatic hydrocarbons produced by Esso Chemical), gasoline, kerosene), aromatic hydrocarbon (e.g. toluen, xylene), or hydrocarbon halide (e.g. trichrene) with one of the following polar solvents:

Alcohols (e.g. methanol, ethanol, water), ethers (e.g. methyl cellosolve, ethyl cellosolve, butyl cellosolve, methylcarbitol, ethylcarbitol, butylcarbitol, dioxane), ketones (e.g. acetone, methyl ethyl ketone), esters (e.g. ethyl acetate, methyl cellosolve acetate, cellosolve acetate, carbitol acetate).

It is also possible to add a dye such as Crystal Violet or Astrazone Red to the developer to dye the image simultaneously with developing.

Developing can be achieved by a known process, for example, the process in which the printing plate is rubbed with a developing pad containing a developer as described above, or the process in which the printing plate is rubbed with a developing brush after pouring the developer over the printing plate.

The above developing process provides a printing plate in which the light sensitive layer is bared as a result of silicone rubber removal in the unexposed portion and in which the silicone rubber layer remains unremoved in the exposed portion.

It is also possible to obtain a printing plate by exposing the original negative film on a negative waterless PS plate.

## EXAMPLES

The present invention is hereinafter described in more detail by means of the following examples. Note that "part(s)" mentioned in the following description means "part(s) by weight" unless otherwise stated.

### Synthesis Example 1

To a 500 cc four-neck flask equipped with an agitator, reflux condenser, thermometer and dropping funnel, 250 g of a 15% hydrochloric acid solution was transferred. While agitating the solution, 129 g (1

mol) of dichlorodimethylsilane was dropwise added over a period of 30 minutes with the reaction temperature maintained at 15° C.

After completion of the reaction, the flask content was washed out with n-hexane into a separation funnel. The washing was washed with a saturated sodium chloride solution until the lower water layer became neutral, after which it was dehydrated with $Na_2SO_4$. This dehydrated product was filtered and transferred to a distiller. After evaporating all the hexane under normal pressure, distillation was conducted under reduced pressure at 50 mmHg and 120° C to yield a distillate with a yield of 67%.

This distillate was analyzed by gas chromatography and identified as

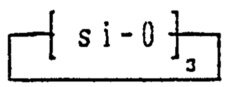 : 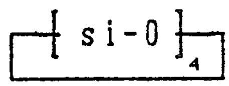 : 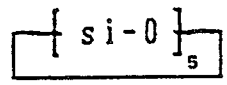

: 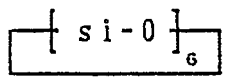 = 1 : 85 : 12 : 2

Separately, 150 mℓ of thoroughly dried tetrahydrofuran and then 15.7 g (150 mmol) of methacryl chloride were placed into a nitrogen-replaced 500 cc four-neck flask equipped with an agitator, reflux condenser, thermometer and dropping funnel. To the dropping funnel, 64.5 g (≈ 125 mℓ) of the previously synthesized polyorganosiloxane oligomer was transferred, and this was followed by ice cooling. The oligomer was dropwise added gradually to the four-neck flask.

After 12-hr agitation at ice temperature, almost all the tetrahydrofuran was distilled under reduced pressure while maintaining the temperature below 10° C. The reaction mixture was then washed several times with an aqueous solution of sodium carbonate and further washed several times with a saturated sodium chloride solution. The yield was abut 89%. The resulting product was dried with $Na_2SO_4$ and filtered to yield a colorless, transparent acryl-modified silicone.

The acryl-modified silicone thus obtained was then copolymerized with a fluorine-containing monomer (Example Compound No. 12).

The copolymerization was achieved by reaction of 80 parts of acryl-modified silicone, 20 parts of Example Compound No. 12, 5 parts of azobisisobutyronitrile and 300 parts of 2:1 mixture of toluene and methyl ethyl ketone, all placed in an eggplant-shaped flask equipped with a reflux condenser, in nitrogen atmosphere at 80° C for 12 hours.

After completion of the reaction, the reaction mixture was dropwise added to a large amount of 2:1 mixture of hexane and 2-propanol to remove the unreacted portion, and this was followed by filtration, whereby a white viscous substance was obtained with a yield of 85%.

The polymer thus obtained was found soluble in fluorine-based solvents (e.g. Flon 113).

## Synthesis Example 2

To a solution of 220 g (0.1 mol) of a silicone of α, ω-dihydroxydimethylpolysiloxane

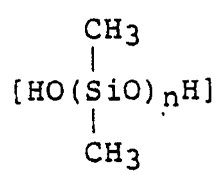

with an average n value of 30 and 9.49 g (0.12 mol) of pyridine in 400 mℓ of diethyl ether, a 10% diethyl ether solution of 12.06 g (0.05 mol) of γ-methacryloxypropylmethyldichlorosilane was dropwise added at room temperature over a period of 1 hour.

The reaction proceeded immediately and a white crystal of pyridine hydrochloride precipitated. After completion of the dropwise addition, the reaction mixture was further agitated at room temperature for 1 more hour; the pyridine hydrochloride crystal was then removed by filtration. The resulting filtrate was then transferred to a separation funnel and washed with 500 mℓ of water while vigorously shaking. After water washing, the separation funnel was kept standing to separate the upper ether layer and the lower water

layer. The separated ether layer was left over night at room temperature in the presence of anhydrous Glauber's salt for dehydration.

The anhydrous Glauber's salt was then removed by filtration. The resulting filtrate was distilled under reduced pressure to remove the ether; 225 g of a colorless, transparent acryl-modified silicone was obtained.

The silicone macromer thus obtained was then copolymerized with a fluorine-containing monomer (Example Compound No. 35).

Copolymerization was achieved by 12-hr reaction in nitrogen atmosphere at 80 °C of 85 parts of the silicone macromer, 15 parts of Example Compound No. 35, 1 part of azobisisobutylonitrile, and 500 parts of a 2:1 mixture of toluene and methyl ethyl ketone, all placed in a three-neck flask equipped with a condenser. After completion of the reaction, the reaction mixture was dropwise added to a large amount of a 2:1 mixture of hexane and 2-propanol to remove the unreacted portion, and this was followed by filtration, whereby a white viscous substance was obtained.

Synthesis Example 3

Five parts of 2-hydroxyethyl methacrylate, 85 parts of silicone macromer (FM-0725, produced by Chisso Corporation), 10 parts of a fluorine-containing monomer (Example Compound No. 18), 1 part of azobisisobutylonitrile, and 700 parts of a 2:1 mixture of toluene and methyl ethyl ketone were all placed in an egg-plant-shaped flask equipped with a condenser, and reaction was carried out in nitrogen atmosphere as 80 °C for 12 hours. After completion of the reaction, the reaction mixture was dropwise added to a large amount of a 2:1 mixture of hexane and 2-propanol, followed by filtration to remove the unreacted portion. The resulting filtrate was dried to yield a white solid.

Example 1

A smooth aluminum plate degreased by an ordinary method was coated with a phenol-formaldehyde resol resin (Sumilight resin PC-1) produced by Sumitomo Durez Co. so that the dry film thickness was 1.0 µm, and this was followed by thermal hardening at 200 °C for 3 minutes.

The primer layer thus obtained was coated with the following light-sensitive composition so that the dry film thickness was 2 µm, and this was followed by drying at 120 °C for 35 seconds to form a light-sensitive layer.

Light-sensitive composition

(1) Partial esterification product (esterification ratio = 49%) of phenol-formaldehyde novolac resin with a number-averaged degree of polymerization of 5.6 and naphthoquinone-1,2-diazido-5-sulfonic acid chloride — 100 parts by weight

(2) 4,4-diphenylmethane diisocyanate — 30 parts by weight

(3) Dibutyltin diacetate — 0.2 parts by weight

The light-sensitive layer obtained above was coated with the following silicone rubber composition and dried at 120 °C for 4 minutes to form a silicone rubber layer having 2.0 µm of dry thickness.

Composition for the silicone rubber layer

| | | |
|---|---|---|
| (1) | Copolymer obtained in Synthesis Example 1 | 10 parts by weight |
| (2) | Solvent (n-heptane/methyl isobutyl ketone = 85/15 by weight) | 100 parts by weight |
| (3) | Dibutytin diacetate | 0.01 parts by weight |

The silicone rubber layer thus obtained was laminated with a polypropyrene film of a thickness of 10 µm to yield a waterless presentized lithographic printing plate.

A negative film was placed in close contact with this waterless PS plate under vacuum conditions and exposed for 100 seconds using Idorfin 2000, produced by Iwasaki Electric Co.

The laminated film was then stripped off and the printing plate surface was gently rubbed with a developing pad moistened with a developing solution comprising 90 parts by weight of Isopar H'(produced by Esso), 7 parts by weight of diethylene glycol monobutyl ether, 3 parts by weight of diethylene glycol monobutyl ether and 5 parts by weight of diethyl succinate, whereby the silicone rubber layer in the exposed portion was removed and the light-sensitive layer became naked.

Negative film images were thus precisely reproduced over the entire surface of the printing plate.

This waterless printing plate was evaluated as to scratch resistance by the following test method:

[Scratch test method]

Using a continuous loading scratch resistance tester (TYPE-HEIDON-18), a saphire needle with R = 0.5 mm was scanned at a rate of 60 cm/min to scratch the nonimaging portion of the waterless printing plate under continuous loading while immersing the plate in Isopar E (organic solvent produced by Esso). The scratched waterless printing plate was applied to a waterless flat bed press and the load on the portion which had become ink-receptive was measured. The greater the load on the portion which has become ink-receptive due to scratching, the more excellent the scratch resistance is. The results are shown in Table 1.

The above waterless printing plate was then applied to a Heidelberg GTO printing press with its wetting water feeder detached, and printing was conducted with TOYO INK ULTRA TUK aqualess G red ink, produced by Toyo Ink, at a printing plate surface temperature of 15 °C, to yield printed matters. The same results were obtained at a printing plate surface temperature of 30 °C or 42 °C.

The printed matters thus obtained were examined for field stains. The results are shown in Table 1.

The symbols used in Table 1 are defined as follows:

◎: No field stain occurred even after 100,000 sheets were printed.
o: A field stain occurred after 50,000 sheets were printed.
Δ: A field stain occurred after 20,000 sheets were printed.
x: A field stain occurred after 5,000 sheets were printed.

Example 2

The procedure of Example 1 was followed but the following composition was used in place of the light sensitive composition used in Example 1, to yield a positive type waterless PS plate.

| | |
|---|---|
| PMMA | 100 parts |
| Glycidyl methacrylate | 25 parts |
| Michler's ketone | 5 parts |

A positive film was brought into contact with the positive type waterless PS plate and exposed, after which it was treated in the same manner as in Example 1 to yield a waterless printing plate, which was evaluated as to scratch resistance and field stains. The results are shown in Table 1.

Comparison Example 1

The procedure of Example 1 was followed but the following composition (Japanese Patent O.P.I. Publication No. 288849/1987) was used in place of the silicone rubber layer composition used in Example 1 to yield a waterless PS plate and then a waterless printing plate, which was evaluated as to scratch

resistance and printability. The results are shown in Table 1.

Composition for the silicone rubber layer

(1) α, ω-dihydroxypolymethylsiloxane (number-average degree of polymerization = 20,000) 100 parts by weight

(2) Vinyltris (methylethylketoxime) silane 10 parts by weight

(3) Dibutylthin diacetate 0.01 part by weight

(4) 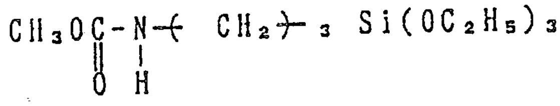 0.5 part by weight

Example 3

The procedure of Example 1 was followed but the compound obtained in Synthesis Example 2 was used in place of the copolymer used for the silicone rubber layer in Example 1 to yield a waterless PS plate and then a waterless printing plate, which was evaluated as to scratch resistance and field stains. The results are shown in Table 1.

Example 4

A smooth aluminum plate degreased by a conventional method was coated with the following composition for primer layer so that the film thickness was 1 μm, followed by heating at 90 °C for 5 minutes for film drying and hardening.

| | |
|---|---|
| Photographic gelatin | 90 parts |
| Glyoxal solution (40% aqueous solution, produced by Daicel Chemical) | 10 parts |

The primer layer thus obtained was coated with the following light sensitive composition so that the dry film thickness was 2 μm, followed by drying at 90 °C for 2 minutes to form a light sensitive layer.

| | |
|---|---|
| Adduct compound of 4 mols of glycidyl acrylate and 1 mol of xylenediamine | 40 parts |
| Michler's ketone | 5 parts |
| Prepolymer AP (acryl resin, produced by Asahi Chemical) | 50 parts |
| Tetramethylxyrylenediisocyanate (produced by Takeda) | 5 parts |
| Dibutyltin laurylate | 1 part |
| Victoria Pure Blue | 0.1 part |
| Methyl cellosolve | 700 parts |

The light sensitive layer thus obtained was coated with the following silicone rubber composition so that the dry film thickness was 2.2 μm, followed by drying at 90 °C for 10 minutes to form a silicone rubber layer.

| | |
|---|---|
| Copolymer obtained in Synthesis Example 2 | 100 parts |
| Triacetoxymethylsilane | 10 parts |
| Dibutyltin laurylate | 1.0 parts |
| Isopar M | 1000 parts |

The waterless PS plate thus obtained was treated and evaluated in the same manner as in Example 1. The results are shown in Table 1.

Example 5

A smooth aluminum plate degreased by a conventional method was coated with the following composition for primer layer so that the film thickness was 1 µm, followed by heating at 150 °C for 5 minutes for film drying and hardening.

| | |
|---|---|
| Epicoat 1004 | 90 parts |
| Diethyltriamine | 10 parts |
| Dibutyltin laurylate | 1 part |
| Methyl ethyl ketone | 700 parts |

The primer layer thus obtained was coated with the following light sensitive composition so that the dry film thickness was 0.5 µm, followed by drying at 90 °C for 2 minutes to form a light sensitive layer.

| | |
|---|---|
| Condensation product of p-diazodiphenylamine hexafluorophosphate and formaldehyde | 50 parts |
| Copolymer of 2-hydroxyethyl methacrylate, acrilonitrile and methyl methacrylate (= 5:2:3, molar ratio) | 50 parts |
| Victoria Pure Blue | 1 part |
| Methyl cellosolve | 700 parts |

The light sensitive layer thus obtained was coated with the following silicone rubber composition so that the dry film thickness was 2.2 µm, followed by drying at 90 °C for 10 minutes to form a silicone rubber layer.

| | |
|---|---|
| Copolymer obtained in Synthesis Example 3 | 95 parts |
| Dibutyltin laurylate | 0.5 part |
| N-($\beta$-aminoethyl)-$\gamma$-aminopropyltrimethoxysilane | 5 parts |
| Isopar M | 1000 parts |

The waterless PS plate thus obtained was treated and evaluated in the same manner as in Example 1. The results are shown in Table 1.

Table 1

| | Scratch strength (g) | Field stains | | |
|---|---|---|---|---|
| | | 25°C | 30°C | 42°C |
| Example 1 | 18.7 | ◎ | ◎ | ◎ |
| Example 2 | 19.0 | ◎ | ◎ | ◎ |
| Example 3 | 18.7 | ◎ | o | Δ |
| Example 4 | 20.0 | ◎ | ◎ | ◎ |
| Example 5 | 20.3 | ◎ | ◎ | ◎ |
| Comparison Example 1 | 18.5 | Δ | Δ | x |

As is evident from Table 1, the present invention is excellent in preventive effect on field stains, particularly at high temperatures, in comparison with Comparison Example, though there is no significant difference in scratch strength.

Note that the present invention proved effective even when the graft polymer of the present invention was replaced with another compound disclosed in the present specification.

## Claims

1. A waterless presensitized lithographic printing plate comprising a support having thereon a light-sensitive layer and a silicone rubber layer in this order, wherein said silicone rubber layer contains a copolymer having a silicone macromer and a fluorine-containing monomer in its molecular structure.

2. The plate of claim 1, wherein said light-sensitive layer comprises an o-quinonediazide compound.

3. The plate of claim 2, wherein the content of said o-quinonediazide compound is 10 to 50 % by weight.

4. The plate of claim 2, wherein the content of said o-quinonediazide compound is 20 to 40 % by weight.

5. The plate of claim 1, wherein said silicone macromer is a compound represented by Formula (I);

Formula (I)

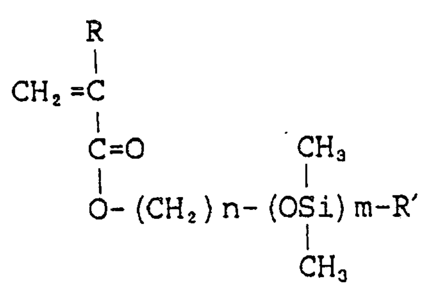

wherein R represents a hydrogen atom or a methyl group; R′ represents an alkyl group or a hydroxy group; n represents an integer of 0, 1 or 2; m represents an integer of 1 to 150.

6. The plate of claim 1, wherein said fluorine-containing monomer is a compound represented by Formula (II);

Formula (II)

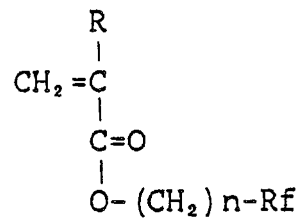

wherein R represents a hydrogen atom or a methyl group; Rf represents a fluorinated alkyl group having not more than 20 carbon atoms; n represents an integer of 0, 1 or 2.

7. The plate of claim 6, wherein said Rf comprises at least one group selected from the group consisting of $-CF_3$, $-CF_2-$, $-CF-$, $-OCF_3$, $-OCF_2-$, $-OCF-$.

8. The plate of claim 6, wherein the fluorine content of said Rf is not less than 30% by weight.

9. The plate of claim 6, wherein the fluorine content of said Rf is not less than 50% by weight.

10. The plate of claim 1, wherein the silicone content of said copolymer is 10 to 95% by weight.

11. The plate of claim 1, wherein the silicone content of said copolymer is 60 to 95% by weight.

12. The plate of claim 1, wherein the fluorine-containing monomer content of said copolymer is 0.1 to 50% by weight.

13. The plate of claim 1, wherein the fluorine-containing monomer content of said copolymer is 0.1 to 20% by weight.

14. The plate of claim 1, wherein the content of said copolymer in the silicone rubber layer is 80 to 100% by weight.

15. The plate of claim 1, wherein the content of said copolymer in the silicone rubber layer is 90 to 100% by weight.